Europäisches Patentamt

European Patent Office

Office européen des brevets

(11) Publication number: **0 136 022**
**B1**

# EUROPEAN PATENT SPECIFICATION

(45) Date of publication of patent specification: **25.07.90**

(21) Application number: **84305446.1**

(22) Date of filing: **09.08.84**

(51) Int. Cl.⁵: **G 11 C 7/06**, G 11 C 7/00, G 11 C 11/40

(54) A dynamic random access memory.

(30) Priority: **26.08.83 JP 156701/83**

(43) Date of publication of application:
**03.04.85 Bulletin 85/14**

(45) Publication of the grant of the patent:
**25.07.90 Bulletin 90/30**

(84) Designated Contracting States:
**DE FR GB**

(56) References cited:
**US-A-4 039 861**
**US-A-4 122 549**

**PATENTS ABSTRACTS OF JAPAN, vol. 3, no. 82
(E-123), 14th July 1979, page 47E123; JP - A - 54
60 531 (HITACHI SEISAKUSHO K.K.) 16-05-1979**

(73) Proprietor: **MITSUBISHI DENKI KABUSHIKI
KAISHA
2-3, Marunouchi 2-chome Chiyoda-ku
Tokyo 100 (JP)**

(72) Inventor: **Mashiko, Koichiro
305, 1-64 Isoshi 4-chome
Takarazuka-shi Hyogo-ken (JP)**
Inventor: **Yamada, Michihiro
305, 1-19, Satsuukida 6-chome
Takarazuka-shi Hyogo-ken (JP)**
Inventor: **Arimoto, Kazutami
Seishin-ryo No. 10, Andoji-cho 2-chome
Itami-shi Hyogo-ken (JP)**
Inventor: **Miyamoto, Hiroshi
14-4, Toneyama 6-chome
Toyonaka-shi Osaka-fu (JP)**
Inventor: **Kobayashi, Toshifumi
Senshin-ryo No. 35, Suzuhara-cho 4-chome
Itami-shi Hyogo-ken (JP)**
Inventor: **Morooka, Yoshikazu
Taihei-ryo No. 10, Andoji-cho 2-chome
Itami-shi Hyogo-ken (JP)**

(74) Representative: **Beresford, Keith Denis Lewis
et al
BERESFORD & Co. 2-5 Warwick Court High
Holborn
London WC1R 5DJ (GB)**

## Description

### Field of the invention

The present invention relates to a dynamic random access memory (hereinafter referred to as a "d-RAM"), and more particularly to that which is capable of maintaining the level of output data during the hidden-refresh operation.

### Background of the invention

In order to explain the background of the invention, reference will be particularly made to Figure 1. The reference numeral 11 designates a pre-amplifier intended to ampify data which is read out from a memory cell accessed by an address signal from the outside. The detailed construction thereof is shown in Figure 2. The reference numeral 12 designates a main-amplifier intended to amplify the output of the pre-amplifier 11, and output the amplified signal as an output data Do. The detailed construction thereof is shown in Figure 3.

The reference numeral 13 designates a driver circuit intended to output a driving signal for driving the main-amplifier 12 to the node N3. In the driver circuit 13 which is constituted by internal transistors Q1, Q2, Q3 and internal nodes N1, N2, the drain of the transistor Q1 is connected to the power supply (Vcc) terminal, and the source thereof is connected to the third node N3 at which the driving signal is obtained. The drain of the transistor Q2 is connected to the third code N3, the source thereof is connected to the earth (Vss), and the gate thereof is connected to the drain of the transistor Q3. The drain of the transistor Q3 is connected to the first node N1, the source thereof is connected to the earth (Vss), and the gate thereof is connected to the second node N2.

The following description of operation is based on the employment of N-channel MOS transistors for the internal transistors Q1 to Q3.

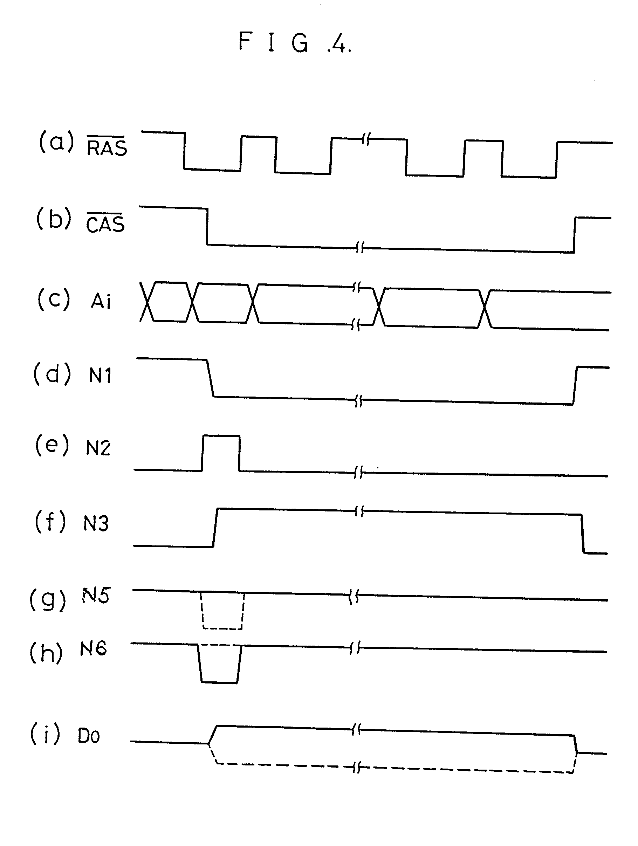

In Figure 4 which shows a timing diagram in a so-called hidden-refresh mode, the (a) shows an inverted signal of Row Address Strobe signal (hereinafter referred to as $\overline{\text{RAS}}$), the (b) shows an inverted signal of Column Address Strobe signal (hereinafter referred to as $\overline{\text{CAS}}$"), the (c) shows an address signal Ai from the outside, the (d) shows a signal at the internal node N1, the (e) shows a signal at the internal node N2, the (f) shows a driving signal at the internal node N3, the (g) and (h) show the signals at nodes N5, N6 of the pre-amplifier 11, respectively, and the (i) shows the output data Do.

Hereupon, the hidden-refresh is operated in such a manner that when the $\overline{\text{RAS}}$ signal falls down on a condition that the $\overline{\text{CAS}}$ signal is low, refreshs of all the memory cells which have the row address designated by the row address signal are executed and completed at the timing when the $\overline{\text{RAS}}$ signal rises up. On the other hand, at the time when the $\overline{\text{CAS}}$ signal falls down while the $\overline{\text{RAS}}$ signal is low data of the memory cell which has the row and column address designated by the address signal at that timing is output from the memory as the output data Do. The "hidden-refresh" means that the refreshs of memory cells are executed while data is output from the memory normally.

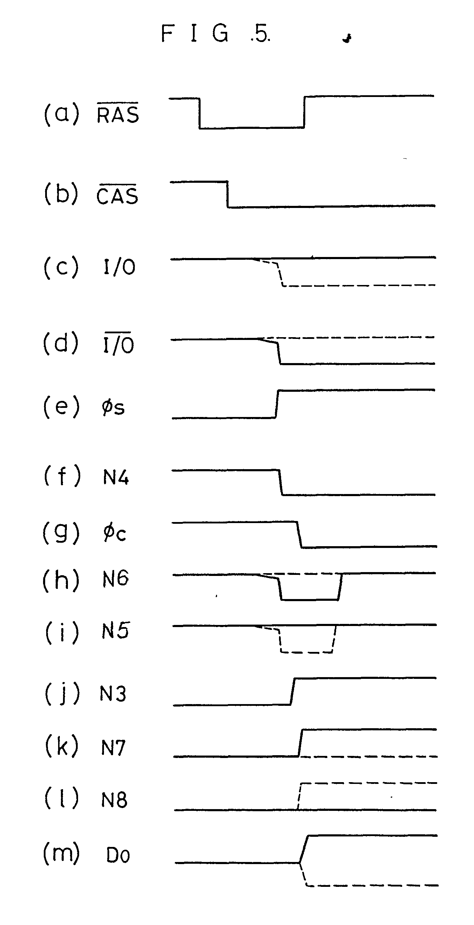

At first the operations of the pre-amplifier 11 and the main-amplifier 12 are described with reference to Figure 5, wherein the (a) shows the $\overline{\text{RAS}}$ signal, the (b) shows the $\overline{\text{CAS}}$ signal, the (c) and (d) show the signals of the I/O bus line 23 and $\overline{\text{I/O}}$ bus line 24 respectively, the (e) shows a set signal $\phi$s input to the pre-amplifier 11, the (f) shows a signal at the node N4, the (g) shows a signal $\phi$c input to the pre-amplifier 11, the (h) and (i) show the signals at the nodes N6, N5 of the pre-amplifier 11 respectively, the (j) shows the driving output at the node N3, the (k) and (l) show signals at the nodes N7 and N8 respectively, and the (m) shows the data output Do of the main amplifier 12.

The information stored in the memory cell selected among the memory cells of the memory cell array 21 is transmitted to the I/O bus line 23 and $\overline{\text{I/O}}$ bus line 24 as complimentary signals (refer to Figure 5 (c), (d)) through the I/O control circuit 22. The I/O bus line 23 and the $\overline{\text{I/O}}$ bus line 24 are connected to the drains of the transistors Q5 and Q6 respectively, which constitute a flip-flop in the pre-amplifier 11. The flip-flop is activated by the rising of a set signal $\phi$s (refer to Figure 5 (e)) input to the pre-amplifier 11 which signal turns on the transistor Q21, thereby making the node N4 discharge. The nodes N5 and N6 are pre-charged to a high voltage through the transistors Q7 and Q8 by the pre-charge signal $\phi$p, respectively. Now it is supposed that the I/O bus line 23 is at "H" (high level), the $\overline{\text{I/O}}$ bus line 24 is at "L" (low level), and these signals are amplified by the flip-flop, then the transistor Q9 is turned off, the transistor Q10 is turned on, and the node N6 is discharged to the earth through the transistors Q10 and Q21. The transistor Q11 which connects between the node N5 and the output D, and the transistor Q12 which connects between the node N6 and the output $\overline{\text{D}}$ are both cut-off transistors which enhances the boot-strap effect of the main-amplifier 12.

In the main-amplifier 12, the voltage at the driving output node N3 rises at the time when the outputs D, $\overline{\text{D}}$ of the pre-amplifier 11 are transmitted to the gates of the transistors Q13, Q14, whereby the voltages of the nodes N7, N8 are determined in accordance with the outputs D, $\overline{\text{D}}$ of the pre-amplifier 11 (refer to Figure 5 (k), (l)). The voltages of the nodes N7, N8 are amplified by the transistors Q15, Q16 in flip-flop connection. The transistors Q17 and Q18 are arranged so as to discharge completely the gate voltage of either of the transistors Q13 and Q14 which is in OFF state. Either of the output transistors Q19, Q20 is turned on in accordance with the voltage of the nodes N7, N8, thereby determining the level of data output Do (refer to Figure 5(m)).

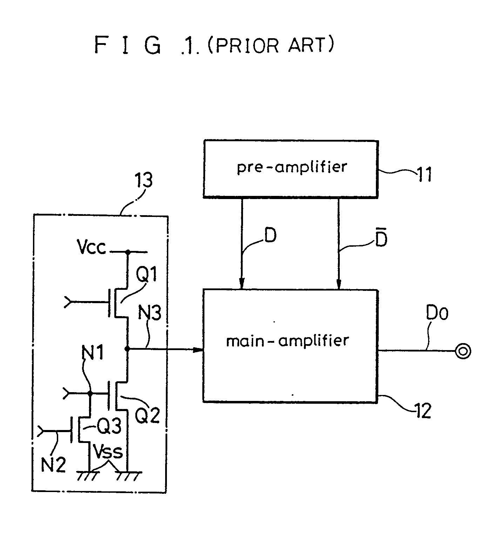

The circuit of Figure 1 will be operated as follows:

When the hidden-refresh operation is started, the node N2 (refer to Figure 4 (e)) becomes "H", and the transistor Q3 is turned on, making the node N1 (refer to Figure 4 (d)) "L". When the node N1 becomes "L", the transistor Q2 is turned off and the transistor Q1 is placed in a conducting state so that the level of driving output N3 rises. The $\overline{RAS}$ signal (refer to Figure 4 (a)) arises whereby the nodes N5, N6 of the pre-amplifier 11 are reset.

The mode shown in Figure 4 is that where the $\overline{CAS}$ signal is made "L" in the first cycle, the column addresses are taken out to execute a readout cycle and thereby the output data is established. Thereafter the $\overline{RAS}$-only-refresh is continued with the $\overline{CAS}$ signal being held at "L" in the usual $\overline{RAS}$-only-refresh mode. Meanwhile, the output data Do from the main-amplifier 12 is held.

At this stage, it is necessary to keep the driving output for driving the main-amplifier 12 at the node N3 (refer to Figure 4 (f)) at "H" in order to keep the output data Do (refer to Figure 4 (i)). It is necessary that the transistor Q2 of the driver circuit 13 is placed in complete OFF state in order to keep the driving output N3 at "H".

However, the voltage of the node N2 which is connected to the gate of the transistor Q3 which is arranged so as to place the node N1 to the earth which node (N1) is connected to the gate of the transistor Q2, will become "L" at the rising of the $\overline{RAS}$ signal shown in Figure 4 (a), as apparent from Figure 4 (e), keeping the state "L" during the hidden-refresh mode. Accordingly, the "L" level of the node N1 (refer to Figure 4 (d)) is an unstable one which is not connected to the earth (Vss) during the hidden-refresh. As the RAS system circuit operates periodically during the hidden-refresh, the voltage of the node N1 varies to the plus side caused by the coupling of noise voltages which arises accompanied with the circuit operation of the RAS system circuit, thereby decreasing the voltage of the driving output N3. The outputs D and D of the pre-amplifier 11 (refer to Figure 4 (g), (h)) are reset by the rising of the RAS signal (refer to Figure 4(a)).

Under such construction shown in Figure 1, the voltage of the driving output N3 decreases during the hidden-refresh operation, unfavourably affecting the holding of the level of output data Do.

A driver circuit similar to that described above is known from Analysis Report of Mosaid Co. Ltd., May 1976 (Mostek Co. Ltd. 4k DRAM MK4027).

## Summary of the invention

The present invention is directed to solve the problems pointed out above, and has for its object to provide a dynamic random access memory capable of holding the level of output data in the hidden-refresh operation.

In accordance with the present invention, there is provided a dynamic random access memory comprising:

a memory cell array including a plurality of memory cells;

a pre-amplifier (11) intended to amplify data which is read out from a memory cell accessed by an address signal;

a main-amplifier (12) intended to amplify the output of the pre-amplifier and output the amplified signal; and

a driver circuit (13) operable in a hidden-refresh operation to output a driving signal for driving the main-amplifier, the driver circuit including:

a first transistor (Q2), the drain of which is connected to a first node (N3) at which the driving signal is provided, and the source of which is earthed (Vss), and the gate of which is connected to a second node (N1);

a pull-up circuit (Q1) operable to pull the first node (N3) high when said first transistor is non-conductive;

a pull-down circuit (Q3) connected to the second node (N1) and operable in response to a signal to commence a hidden refresh operating to pull the second node (N1) low to render the first transistor (Q2) non-conductive and the first node (N3) high;

the gate of the first transistor (Q2) also being responsive to a signal (1) applied to the second node (N1) to render the first transistor (Q2) conductive and the first node (N3) low; characterised by:

a second transistor (Q4), the gate of which is connected to the first node (N3), the drain of which is connected to the second node (N1), and the source of which is earthed (Vss), the second transistor being operable to achieve a voltage latch effect upon the first node (N3) in order to maintain the first node (N3) high and thus maintain the level of output data from the memory array during row and common addressing of the memory array within the hidden refresh operation, and the signal to terminate the hidden refresh operation being operable to unlatch the latch effect on the first node (N3) by causing the first transistor (Q2) to conduct.

## Brief description of the drawings

Figure 1 is a circuit diagram showing a conventional d-RAM;

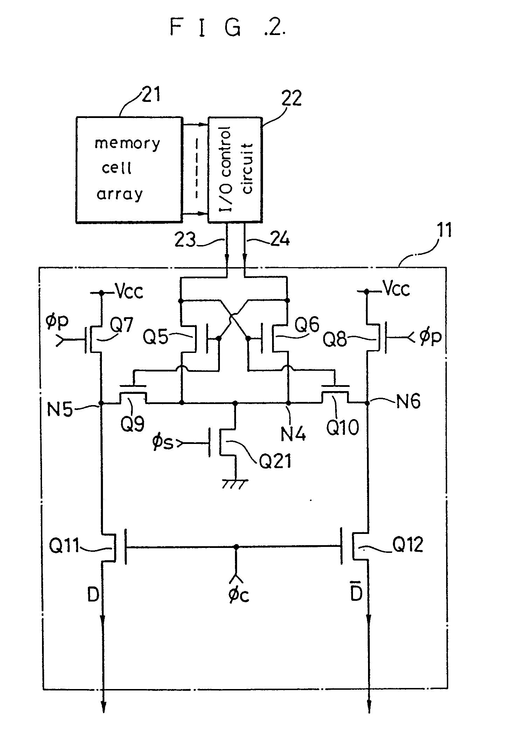

Figure 2 is a circuit diagram of the pre-amplifier of Figure 1;

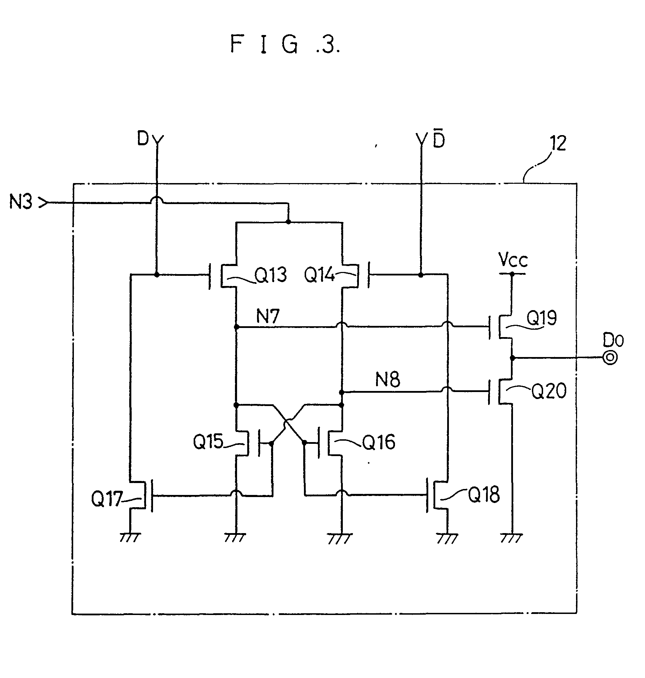

Figure 3 is a circuit diagram of the main-amplifier of Figure 1;

Figure 4 is a timing diagram exemplifying an operation of Figure 1 in the hidden-refresh mode;

Figure 5 is a timing diagram exemplifying operations of the pre- and main-amplifier;

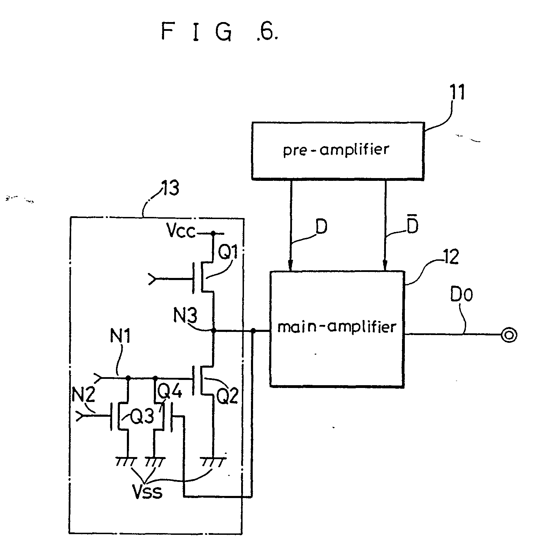

Figure 6 is a circuit diagram of a d'RAM as one embodiment of the present invention.

## Detailed description of the preferred embodiments

Reference will now be made to Figure 6, wherein like reference numerals are used to designate like or corresponding parts or elements through Figures 1 and 3. The reference character Q4 designates a transistor to the gate whereof the driving output at the node N3 is supplied, with the drain thereof being connected to the node N1, and with the source thereof being connected to the earth (Vss).

The drain of the transistor Q1 is connected to the power supply (Vcc) terminal and the source thereof is connected to the third node N3 whereat the driving output is obtained. The drain of the transistor (first transistor) Q2 is connected to the third node N3, the source thereof is connected to the earth (Vss), and the gate thereof is connected to the drain of the transistor (second transistor) Q4. The drain of the transistor Q3 is connected to the node N1, the source thereof is connected to the earth (Vss), and the gate thereof is connected to the second node N2.

The device of Figure 6 is operated as follows:

The operations of the pre- and main-amplifiers 11, 12 and the operation from the start of the hidden-refresh to the reset of the nodes N5, N6 of the pre-amplifier 11 by the $\overline{RAS}$ signal is the same as above, as described concerned with the conventional device.

The transistor Q4 is held at its ON state while the driving output N3 is held "H" after the nodes N5, N6, of the pre-amplifier 11 are reset, whereby the node N1 is connected to the earth (Vss), and the voltage of the node N1 does not arise, regardless of the couplings of noises accompanied with the operation of the $\overline{RAS}$ system circuit.

Accordingly, the transistor Q2 is held at its OFF state during the hidden-refresh operation, whereby the driving output N3 is held at "H" and the output data Do from the main-amplifier 12 is maintained at its level. This is caused by the functions of the latch circuit constituted by the nodes N1, N2 and transistors Q4, Q2.

The foregoing description is based on the employment of N-channel MOS transistor circuits, but the present invention is not limited to it. P-channel MOS transistor circuits and complimentary MOS transistor circuits can be similarly used.

As evident from the foregoing description, according to the present invention, a latch is constituted between the node whereat the driving output is obtained and the gate of the driving transistor, thereby realizing a d-RAM wherein the level of output data does not decrease in the hidden-refresh operation.

**Claim**

A dynamic random access memory comprising:

a memory cell array including a plurality of memory cells;

a pre-amplifier (11) intended to amplify data which is read out from a memory cell accessed to an address signal;

a main-amplifier (12) intended to amplify the output of the pre-amplifier and output the amplified signal; and

a driver circuit (13) operable in a hidden-refresh operation to output a driving signal for driving the main-amplifier, the driver circuit including:

a first transistor (Q2), the drain of which is connected to a first node (N3) at which the driving signal is provided, and the source of which is earthed (Vss), and the gate of which is connected to a second node (N1);

a pull-up circuit (Q1) operable to pull the first node (N3) high when said first transistor is non-conductive;

a pull-down circuit (Q3) connected to the second node (N1) and operable in response to a signal to commence a hidden refresh operation to pull the second node (N1) low to render the first transistor (Q2) non-conductive and the first node (N3) high;

the gate of the first transistor (Q2) also being responsive to a signal to terminate the hidden refresh operation applied to the second node (N1) to render the first transistor (Q2) conductive and the first node (N3) low; characterized by:

a second transistor (Q4), the gate of which is connected to the first node (N3), the drain of which is connected to the second node (N1), and the source of which is earthed (Vss), the second transistor being operable to achieve a voltage latch effect upon the first node (N3) in order to maintain the first node (N3) high and thus maintain the level of output data from the memory array during row and common addressing of the memory array within the hidden refresh operation, and the signal to terminate the hidden refresh operation being operable to unlatch the latch effect on the first node (N3) by causing the first transistor (Q2) to conduct.

**Patentanspruch**

Dynamischer RAM-Speicher mit:

einer Speicherzellenanordnung mit einer Mehrzahl von Speicherzellen;

einem Vorverstärker (11) zur Verstärkung von Daten, die aus einer Speicherzelle durch Zugriff mit einem Adress-Signal ausgelesen wurden;

einem Hauptverstärker (12) zur Verstärkung des Ausgangssignals des Vorverstärkers und zur Erzeugung eines verstärkten Signals und

einer Treiberschaltung (13) zur Erzeugung eines Treibersignals für den Hauptverstärker, die in einem "Hintergrund-Wiederholzyklus" ("hidden refresh") betreibbar ist,

bei welchem die Treiberschaltung folgende Komponenten aufweist:

einen ersten Transistor (Q2), dessen Drainanschluß mit einem ersten Knotenpunkt (N3) verbunden ist an dem das Treibersignal angelegt ist, dessen Sourceanschluß geerdet ist (Vss) und dessen Gateanschluß mit einem zweiten Knotenpunkt (N1) verbunden ist;

einer Schaltung (Q1) zum Anheben des Potentials des ersten Knotenpunkts (N3) wenn der erste Transistor nichtleitend ist;

eine Schaltung (Q3), die mit dem zweiten Knotenpunkt (N1) verbunden ist und in Abhängigkeit von einem Signal zur Einleitung der Betriebsart "Verdeckte Auffrischung" (hidden refresh) den zweiten Knotenpunkt (N1) auf niedriges Potential legt, um den ersten Transistor (Q2) wieder nichtleitend zu machen und den ersten Knotenpunkt (N3) auf hohes Potential zu legen; und bei dem

das Gate des ersten Transistors (Q2) außerdem auf ein Signal zum Beenden der Betriebsart "Verdeckte Auffrischung" anspricht, das an den zweiten Knotenpunkt (N1) angelegt ist, um den ersten Transistor (Q2) wieder in den leitenden Zustand zu bringen und den ersten Knotenpunkt (N3) auf niedriges Potential zu legen, gekennzeichnet durch:

einen zweiten Transistor (Q4), dessen Gatenanschluß mit dem ersten Knotenpunkt (N3) und dessen Drainanschluß mit dem zweiten Knotenpunkt (N1) verbunden und dessen Sourceanschluß geerdet ist (Vss), wobei der zweite Transistor so betreibbar ist, daß er eine selbsthaltende Spannung am ersten Knotenpunkt (N3) erzeugt, um diesen Knotenpunkt auf hohem Potential zu halten und damit den Pegel der aus der Speicheranordnung während der zeilenweisen und gemeinsamen Adressierung der Speicheranordnung während der Betriebsart "Verdeckte Auffrischung" ausgelesenen Daten zu halten, und wobei das Signal zur Beendigung dieser Betriebsart den Halteeffekt am ersten Knotenpunkt (N3) dadurch beendet, daß der erste Transistor (Q2) leitend geschaltet wird.

**Revendication**

Une mémoire vive dynamique comprenant:

un réseau de cellules de mémoire comprenant un ensemble de cellules de mémoire;

un préamplificateur (11) destiné à amplifier des données qui sont lues dans une cellule de mémoire qui fait l'objet d'un accès au moyen d'un signal d'adresse;

un amplificateur principal (12) destiné à amplifier le signal de sortie du préamplificateur et à émettre le signal amplifié; et

un circuit d'attaque (13) que l'on peut faire fonctionner dans une opération de régénération cachée de façon à émettre un signal d'attaque pour attaquer l'amplificateur principal, le circuit d'attaque comprenant:

un premier transistor (Q2) dont le drain est connecté à un premier noeud (N3) sur lequel le signal d'attaque est appliqué, dont la source est reliée à la masse (Vss) et dont la grille est connectée à un second noeud (N1);

un circuit de rappel au niveau haut (Q1) capable de rappeler le premier noeud (N3) au niveau haut lorsque le premier transistor est bloqué;

un circuit de rappel au niveau bas (Q3), connecté au second noeud (N1) et pouvant fonctionner sous la dépendance d'un signal de commencement d'une opération de régénération cachée, de façon à rappeler le second noeud (N1) au niveau bas, pour bloquer le premier transistor (Q2) et pour faire passer le premier noeud (N3) au niveau haut;

la grille du premier transistor (Q2) réagissant également à un signal de terminaison de l'opération de régénération cachée, qui est appliqué au second noeud (N1), en débloquant le premier transistor (Q2) et en faisant passer le premier noeud (N3) au niveau bas; caractérisée par:

un second transistor (Q4) dont la grille est connectée au premier neud (N3), dont le drain est connecté au second noeud (N1) et dont la source est reliée à la masse (Vss), le second transistor pouvant réaliser un effet de verrouillage de tension sur le premier noeud (N3) dans le but de maintenir le premier noeud (N3) au niveau haut, et de maintenir ainsi le niveau des données de sortie du réseau de mémoire pendant l'adressage de rangée et l'addressage commun du réseau de mémoire, au cours de l'opération de régénération cachée, et le signal de terminaison de l'opération de régénération cachée étant capable de déverrouiller l'effet de verouillage sur le premier noeud (N3) en provoquant la conduction du premier transistor (Q2).

EP 0 136 022 B1

# F I G .1. (PRIOR ART)

# F I G .2.

F I G .3.

# F I G .4.

(a) $\overline{RAS}$

(b) $\overline{CAS}$

(c) Ai

(d) N1

(e) N2

(f) N3

(g) N5

(h) N6

(i) Do

F I G .5.

(a) $\overline{RAS}$

(b) $\overline{CAS}$

(c) I/0

(d) $\overline{I/0}$

(e) $\phi s$

(f) N4

(g) $\phi c$

(h) N6

(i) N5

(j) N3

(k) N7

(l) N8

(m) D0

# F I G .6.